# FASCICULE DE BREVET EUROPEEN

(11) **EP 3 396 720 B1**
(45) Date de publication et mention de la délivrance du brevet: **22.01.2020**
(21) Numéro de dépôt: 18168455.6
(22) Date de dépôt: 20.04.2018
(51) Int. Cl.: H01L 31/0296, H01L 27/146, H01L 31/102, H01L 31/18

(54) **PROCEDE DE REALISATION D'UNE MATRICE DE PHOTODIODES A STRUCTURES EN MESA**
HERSTELLUNGSVERFAHREN EINER FOTODIODENMATRIX MIT MESA-STRUKTUREN
METHOD FOR PRODUCING A PHOTODIODE ARRAY HAVING MESA STRUCTURES

(30) Priorité: 24.04.2017 FR 1753514
(43) Date de publication de la demande: 31.10.2018
(73) Titulaire: Commissariat à l'Energie Atomique et aux Energies Alternatives, 75015 Paris (FR)
(72) Inventeur: BADANO, Giacomo, 38054 GRENOBLE Cedex 9 (FR); LOBRE, Clément, 38054 GRENOBLE Cedex 9 (FR); ESPIAU DE LAMAESTRE, Roch, 38054 GRENOBLE Cedex 9 (FR); CHAMONAL, Jean-Paul, 38054 GRENOBLE Cedex 9 (FR)
(74) Mandataire: GIE Innovation Competence Group

(56) Documents cités:
- US-A1- 2016 380 017
- DEMIR H V ET AL: "Self-Aligning Planarization and Passivation for Integration Applications in III-V Semiconductor Devices", IEEE TRANSACTIONS ON SEMICONDUCTOR MANUFACTURING, IEEE SERVICE CENTER, PISCATAWAY, NJ, US, vol. 18, no. 1, 1 février 2005 (2005-02-01), pages 182-189, XP011126740, ISSN: 0894-6507, DOI: 10.1109/TSM.2004.841834

## Description

### DOMAINE TECHNIQUE

Le domaine de l'invention est celui des photodiodes à structures en mesa, utilisées notamment pour détecter un rayonnement infrarouge.

### ÉTAT DE LA TECHNIQUE ANTÉRIEURE

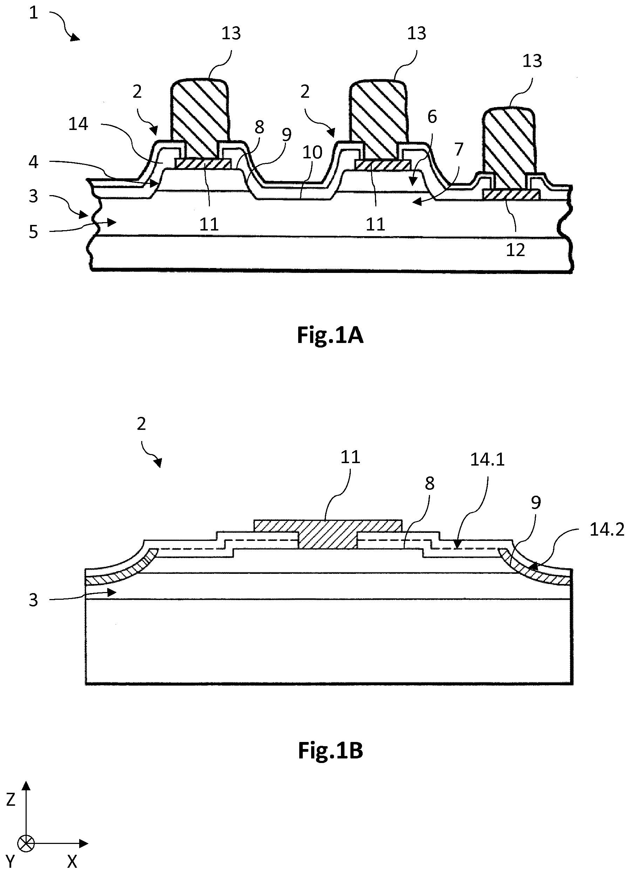

La figure 1A illustre un exemple de matrice 1 de photodiodes 2 à structures en mesa en CdHgTe tel que décrit dans le document US5401986. Chaque photodiode 2 présente une structure en mesa, c'est-à-dire qu'elle est formée d'une partie supérieure 4 d'une couche dite utile 3 en CdHgTe, cette partie supérieure 4 étant en saillie vis-à-vis d'une partie inférieure 5 de la couche utile 3, appelée base, s'étendant sous les photodiodes 2. Chaque partie supérieure 4 comporte une première portion 6, ici dopée P, qui recouvre une deuxième portion 7, ici dopée N, de manière à former une jonction PN. Chaque structure en mesa 2, i.e. la partie 4 en saillie vis-à-vis de la base 5, présente une jonction PN qui lui est propre, formant ainsi une photodiode 2.

Chaque photodiode 2 comporte une surface supérieure 8 dont la bordure est délimitée par des surfaces latérales 9 qui forment les flancs de la structure en mesa 2. Les flancs 9 des structures 2 adjacentes se rejoignent au niveau d'une surface inférieure 10 qui entoure et délimite chaque structure en mesa 2.

Chaque photodiode 2 comporte en outre un plot électriquement conducteur, appelé contact diode 11, situé au contact de la surface supérieure 8. La matrice 1 comporte également au moins un plot électriquement conducteur, appelé contact substrat 12, situé au contact de la base 5. Les contacts diode 11 et le contact substrat 12 sont destinés à assurer la polarisation des photodiodes 2 et la mesure du signal électrique de détection. Pour cela, ils sont destinés à être connectés à un circuit de lecture (non représenté) par le biais d'éléments 13 d'interconnexion électrique tels que, par exemple, des plots d'indium.

Les flancs 9 des photodiodes 2 sont généralement passivés au moyen d'une couche dite de passivation 14. Celle-ci est réalisée en un matériau semiconducteur dont les propriétés permettent de limiter la recombinaison, au niveau des flancs 9, des porteurs minoritaires photogénérés, et de limiter le bruit de détection lié notamment à la création spontanée de porteurs minoritaires par génération-recombinaison. Ce matériau de passivation peut ainsi présenter une énergie de bande interdite supérieure à celle de la couche utile 3, et peut être, par exemple, du CdTe, CdZnTe, voire du CdSeTe.

Le procédé de réalisation décrit dans ce document prévoit les étapes suivantes : formation des structures en mesa 2; formation des contacts diode 11 sur la surface supérieure 8; dépôt de la couche de passivation 14 de manière à recouvrir les flancs 9 des structures en mesa 2 ainsi que les contacts diode 11; réalisation d'ouvertures débouchantes dans la couche de passivation 14 pour exposer une surface des contacts diode 11; puis formation des plots d'interconnexion 13 en indium.

Cependant, ce procédé prévoit l'utilisation de plusieurs masques de gravure ou de dépôt, et donc plusieurs étapes de structuration des masques par photolithographie, ce qui peut induire une imprécision sur le positionnement des contacts diode 11 et de la couche de passivation 14 vis-à-vis des structures en mesa 2. Cette imprécision de positionnement peut être particulièrement contraignante lorsqu'on souhaite réaliser une matrice 1 de photodiodes 2 à petit pas, c'est-à-dire lorsque le pas est inférieur ou égal à environ 10µm.

La figure 1B illustre un autre exemple de réalisation d'une matrice 1 de photodiodes 2 à structures en mesa, tel que décrit dans le document US5192695, qui permet d'obtenir un auto-alignement de la couche de passivation, ici réalisée en un matériau métallique, vis-à-vis des structures en mesa 2.

Le procédé de réalisation décrit dans ce document prévoit les étapes suivantes : dépôt d'une première couche de passivation 14.1 en CdTe sur la couche utile 3 ; formation des structures en mesa 2; dépôt d'une deuxième couche de passivation 14.2 en un matériau métallique, ici de l'indium, sur les flancs 9 des structures en mesa 2 et sur le masque de gravure, suivi de la suppression du masque de gravure et donc de la partie de la couche de passivation métallique 14.2 le recouvrant ; réalisation d'ouvertures débouchantes dans la première couche de passivation 14.1 pour exposer une surface supérieure 8 des structures en mesa 2 ; puis formation des contacts diode 11.

L'auto-alignement de la couche de passivation métallique 14.2 vis-à-vis des structures en mesa 2 est obtenu ici par le fait de conserver, lors du dépôt de la couche de passivation métallique 14.2, le masque de gravure utilisé pour la formation des structures en mesa 2. Dans la mesure où cette couche de passivation 14.2 est réalisée en un matériau métallique, ici en indium, il est possible de réaliser la dissolution chimique du masque de gravure, ce qui entraîne la suppression (*lift-off,* en anglais) des parties de la couche de passivation métallique 14.2 qui le recouvre. Ainsi la couche de passivation métallique 14.2 est auto-alignée vis-à-vis des structures en mesa 2.

Cependant, ce procédé nécessite, pour l'obtention de l'auto-alignement de la passivation des flancs 9, de réaliser la deuxième couche de passivation 14.2 en un matériau métallique. Par ailleurs, ce procédé peut également induire une imprécision sur le positionnement des contacts diode 11 vis-à-vis des structures en mesa 2, ce qui peut devenir contraignant lorsqu'on souhaite réaliser une matrice 1 de photodiodes 2 à petit pas.

Le document "Self-Aligning Planarization and Passivation for intégration Applications in III-V Semiconductor Devices", H.V. Demir et Al., IEEE Transactions on Semiconductor Manufacturing Vol. 18 No. 1 (2005) décrit un procédé de réalisation de photodiodes structurées en plot.

### EXPOSÉ DE L'INVENTION

L'invention a pour objectif de remédier au moins en partie aux inconvénients de l'art antérieur. Pour cela, l'objet de l'invention est un procédé de réalisation d'une matrice de photodiodes à structures en mesa, comportant au moins les étapes suivantes :
a) réalisation d'une couche dite utile comportant une face supérieure et une face inférieure opposée, reposant sur une couche support au niveau de la face inférieure, comportant un empilement d'une première zone située au niveau de la face supérieure et présentant un premier type de dopage, et d'une deuxième zone située entre la première zone et la couche support présentant un deuxième type de dopage opposé au premier type ;
b) réalisation d'un masque de gravure disposé sur ladite face supérieure, formé d'une pluralité de plots dits de gravure distincts les uns des autres ;
c) gravure humide d'une partie de la couche utile située entre les plots de gravure, formant ainsi une pluralité de photodiodes à structures en mesa présentant chacune une surface supérieure sur laquelle repose l'un desdits plots de gravure, ladite gravure humide étant adaptée de sorte que la surface supérieure de chaque photodiode présente une dimension latérale moyenne inférieure à celle du plot de gravure correspondant, formant ainsi un décrochement entre le plot de gravure et la photodiode correspondante ;
d) dépôt conforme, sur les plots de gravure et les photodiodes, d'une couche de passivation en au moins un matériau diélectrique ou semiconducteur, avec des conditions de dépôt choisies de sorte que la couche de passivation présente d'une part une épaisseur locale inférieure ou égale à 200nm sous le décrochement, et d'autre part une structure polycristalline colonnaire dont les colonnes s'étendent longitudinalement suivant l'épaisseur de la couche de passivation avec une dimension transversale constante, et sont séparées latéralement les unes des autres par des joints de grains ;
e) suppression des plots de gravure par dissolution chimique, laissant ainsi exposée la surface supérieure, une surface dite latérale des photodiodes, qui entoure la surface supérieure, étant recouverte par la couche de passivation ;
f) réalisation de plots électriquement conducteurs sur et au contact de la surface supérieure.

Les conditions de dépôt relatives à l'épaisseur locale de la couche de passivation peuvent classiquement être la durée de dépôt, entre autres. Les conditions de dépôt relatives à la structure polycristalline colonnaire peuvent classiquement être la température et la pression de dépôt, comme l'exprime le diagramme de Thornton, et plus précisément le rapport entre la température de dépôt et la température de fusion du matériau déposé. La couche située sous le décrochement correspond à une portion de la couche recouvrant la zone du flanc de la photodiode située en regard, c'est-à-dire à la perpendiculaire, du décrochement. Un joint de grains est une interface, dans la couche en un matériau cristallin, entre deux cristaux de même structure cristallographique et de même composition, mais d'orientation différente.

Certains aspects préférés mais non limitatifs de ce procédé sont les suivants.

Lors de l'étape de réalisation des plots conducteurs, chaque plot conducteur peut recouvrir entièrement la surface supérieure de la photodiode correspondante.

Chaque plot conducteur peut recouvrir en outre une partie d'une surface latérale de la photodiode correspondante qui entoure la surface supérieure.

Les plots de gravure peuvent être dimensionnés et la gravure humide peut être adaptée de sorte que le rapport entre une hauteur des plots de gravure sur une profondeur des photodiodes est supérieur ou égal à 2.

Les plots de gravure peuvent être dimensionnés de sorte que le rapport entre une hauteur des plots de gravure sur un espacement entre deux plots de gravure adjacents est supérieur à 1.

Les photodiodes peuvent être espacées les uns des autres périodiquement d'un pas inférieur ou égal à 10µm.

Le décrochement peut présenter une dimension, suivant une direction parallèle à un plan principal de la couche utile, supérieure à 50nm.

La couche utile peut être réalisée en un alliage semiconducteur comportant des éléments des colonnes II et VI du tableau périodique.

La couche de passivation peut être réalisée en au moins un alliage semiconducteur comportant des éléments des colonnes II et VI du tableau périodique.

La couche de passivation peut être déposée par pulvérisation cathodique.

La couche de passivation peut présenter une épaisseur, au niveau de la surface latérale des photodiodes, qui diminue à mesure que l'on se rapproche de la surface supérieure.

L'étape de réalisation des plots conducteurs peut comporter un dépôt d'une couche continue en un matériau électriquement conducteur de manière à recouvrir la couche de passivation et la surface supérieure des photodiodes, suivi d'une structuration de la couche continue sous forme de plots conducteurs distincts les uns des autres par photolithographie et gravure.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés, sur lesquels :
Les figures 1A et 1B, déjà décrites, sont des vues en coupe, schématiques et partielles, de matrices de photodiodes à structures en mesa, selon des exemples de l'art antérieur ;
les figures 2A à 2H sont des vues en coupe, schématiques et partielles, de différentes étapes de réalisation d'une matrice de photodiodes à structures en mesa selon un exemple d'un mode de réalisation ;
les figures 3A et 3B sont des vues en coupe, schématiques et partielles, d'une matrice de photodiodes à structures en mesa, pour différents exemples de dimensionnement des plots de gravure ;
la figure 4 est une vue en coupe, schématique et partielle, d'une matrice de photodiodes dans laquelle le contact substrat est situé dans une zone de la couche utile ne comportant pas de structures en mesa ;
les figures 5A à 5C sont des vues en coupe, schématiques et partielles, de différentes étapes de réalisation des contacts diodes et substrat d'une matrice de photodiodes à structures en mesa selon un autre exemple d'un mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

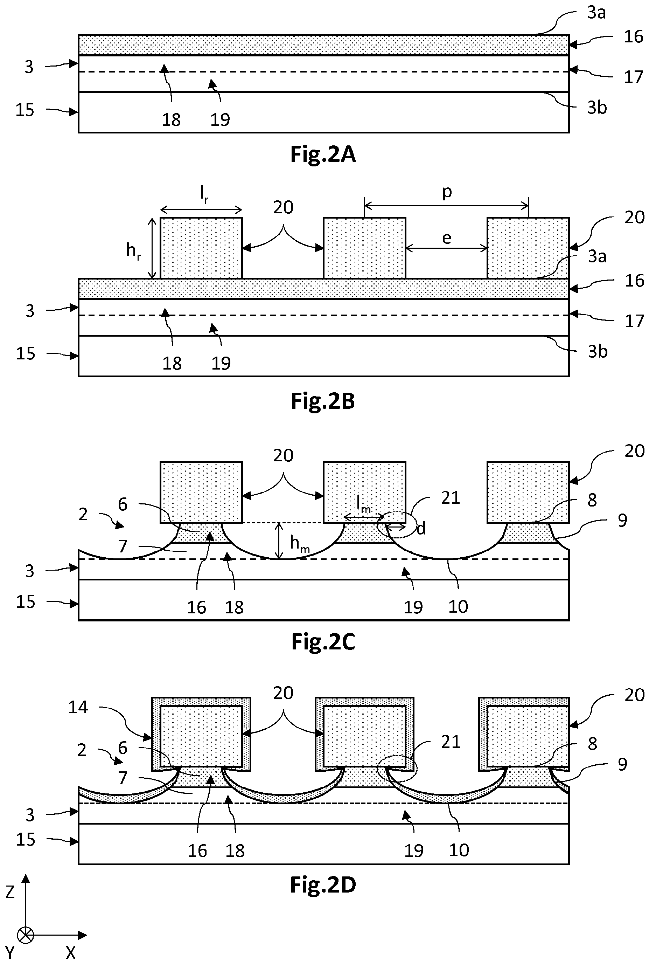

Les figures 2A à 2H illustrent différentes étapes d'un procédé de réalisation d'une matrice de photodiodes à structures en mesa selon un exemple de mode de réalisation. Dans cet exemple, la couche utile est réalisée en un alliage de cadmium, mercure et tellure, ici en CdHgTe, obtenu par croissance épitaxiale à partir d'un substrat de croissance, appelée par la suite couche support. Par couche utile, on entend une couche réalisée en au moins un matériau semiconducteur dont au moins une partie est apte à absorber le rayonnement électromagnétique à détecter.

On définit ici et pour la suite de la description un repère direct tridimensionnel orthogonal (X,Y,Z), où les axes X et Y forment un plan parallèle au plan d'une couche support, et où l'axe Z est orienté suivant l'épaisseur des couches. Dans la suite de la description, les termes « vertical » et « verticalement » s'entendent comme étant relatifs à une orientation sensiblement parallèle à l'axe Z. Par ailleurs, les termes « inférieur » et « supérieur » s'entendent comme étant relatifs à un positionnement croissant lorsqu'on s'éloigne de la couche support suivant la direction +Z.

La couche utile est ici réalisée en un matériau semiconducteur adapté à absorber le rayonnement électromagnétique à détecter. Il peut être formé d'un alliage d'éléments des colonnes II et VI du tableau périodique. Dans cet exemple, le matériau semiconducteur est un alliage de cadmium, mercure et tellure de type CdₓHg₁₋ₓTe, avec une proportion atomique x de cadmium comprise entre 0 et 1, les bornes étant exclues. La proportion atomique x en cadmium est choisie en fonction du rayonnement électromagnétique à détecter. A titre d'exemples, elle peut être de l'ordre de 0,22 lorsqu'on souhaite détecter un rayonnement dans l'infrarouge lointain (LWIR, pour *Long Wave InfraRed,* en anglais), être de l'ordre de 0,3 lorsqu'on souhaite détecter un rayonnement dans le moyen infrarouge (MWIR, pour *Middle Wave InfraRed,* en anglais), voire être de l'ordre de 0,4 lorsque le rayonnement à détecter est dans le proche infrarouge (SWIR, pour *Small Wave InfraRed,* en anglais). De manière alternative, le matériau semiconducteur de la couche utile peut être différent du CdHgTe, et peut être choisi parmi les alliages comportant des éléments des colonnes III et V de la classification périodique, par exemple l'InGaAs et l'InSb.

Le matériau semiconducteur du substrat de croissance est choisi pour présenter un bon accord du paramètre de maille avec le matériau semiconducteur de la couche utile. Si le substrat de croissance est conservé après réalisation de la matrice de photodiodes, il est choisi de manière à être en outre transparent aux longueurs d'onde du rayonnement électromagnétique que l'on souhaite détecter. Dans le cas où le matériau semiconducteur de la couche utile est en CdHgTe, celui du substrat de croissance peut être en un alliage de cadmium, zinc et tellure, par exemple en CdZnTe.

En référence à la figure 2A, on réalise tout d'abord la croissance épitaxiale de la couche utile 3 à partir du substrat de croissance 15, par exemple par épitaxie par jets moléculaires (MBE, pour *Molecular Beam Epitaxy,* en anglais), par épitaxie en phase liquide (LPE, pour *Liquid Phase Epitaxy,* en anglais), voire par dépôt chimique en phase vapeur aux organométalliques (MOCVD, pour *Métal Organic Chemical Vapour Deposition,* en anglais).

La couche utile 3 présente une première face dite supérieure 3a et une deuxième face dite inférieure 3b opposée à la première face. Elle est au contact de la couche support 15 au niveau de la face inférieure 3b.

La couche utile 3 présente ici une première zone 16 dite supérieure, présentant un premier type de dopage, N ou P, ici de type P, et une deuxième zone 17 dite inférieure, présentant un second type de dopage P ou N, opposé au premier type, ici de type N. En variante, les types de dopage entre les zones inférieure 17 et supérieure 16 peuvent être inversés. La zone supérieure 16 dopée P s'étend dans le plan XY de la couche utile 3, et s'étend suivant l'axe Z à partir de la face supérieure 3a. La zone inférieure 17 dopée N s'étend également dans le plan XY de la couche utile 3, et est située entre la zone supérieure 16 dopée P et la face inférieure 3b.

Dans cet exemple, et à titre purement illustratif, la couche utile 3 présente une épaisseur de l'ordre de 1,5µm, l'épaisseur de la zone inférieure 17 dopée N est de 1µm environ, et celle de la zone supérieure 16 dopée P de 0,5µm environ. La zone supérieure 16 dopée P peut présenter une densité de dopage de l'ordre de 10¹⁸ atomes/cm³, et la zone inférieure 17 dopée N une densité de dopage de l'ordre de 10¹⁵ atomes/cm³. Le dopage des différentes zones de la couche utile 3 peut être effectué par différentes techniques connues. A titre d'exemple, le dopage N de la zone inférieure 17 peut être effectué lors de la croissance épitaxiale du CdHgTe par incorporation d'un élément dopant dit donneur, par exemple du bore ou de l'indium. Le dopage P peut être effectué après croissance de la couche utile 3 par implantation ionique d'un élément dopant dit accepteur, par exemple de l'arsenic. Une ou plusieurs étapes de recuit peuvent être avantageusement effectuées, dans le but d'assurer une diffusion et/ou l'activation des éléments dopants, voire de combler d'éventuelles lacunes de mercure.

Dans cet exemple, et de manière avantageuse, la zone inférieure 17 dopée N est formée d'une première région 18 dopée N, présentant une première densité de dopage par exemple de l'ordre de 10¹⁵ atomes/cm³, qui s'étend à partir de la zone supérieure 16 dopée P suivant la direction -Z, et d'une deuxième région 19 dopée N+ présentant une deuxième densité de dopage supérieure à la première densité, par exemple de l'ordre de 10¹⁶ atomes/cm³, qui s'étend entre la première région 18 dopée N et la face inférieure 3b. La première région 18 dopée N peut avoir une épaisseur de 0,5µm environ et la deuxième région 19 dopée N+ une épaisseur 0,5µm environ. La région 19 dopée N+ forme une partie de la couche utile 3, appelée base, s'étendant sous toutes les photodiodes 2 et destinée à présenter un même potentiel électrique.

Dans cet exemple, et de manière avantageuse, la région 19 dopée N+ présente une proportion atomique de cadmium supérieure à celles de la région 18 dopée N et de la zone supérieure 16 dopée P. Cette région 19 dopée N+ présente alors une énergie de bande interdite supérieure à celles de la région 18 dopée N et de la zone supérieure 16 dopée P, de manière à éviter qu'elle puisse absorber au moins une partie du rayonnement électromagnétique à détecter. La région 18 dopée N et la zone supérieure 16 dopée P présentent une proportion atomique en cadmium sensiblement identique. La variation de la proportion atomique de cadmium peut être obtenue lors de la croissance de la couche utile 3, notamment lorsque celle-ci est obtenue par épitaxie par jets moléculaires, entre autres.

En référence à la figure 2B, on dépose un masque de gravure sur la face supérieure 3a de la couche utile 3. Le masque de gravure se présente sous la forme d'une pluralité de plots 20 dits de gravure distincts les uns des autres, disposés ici de manière périodique. Le masque de gravure peut être une résine photosensible.

Les plots de gravure 20 présentent une hauteur moyenne suivant l'axe Z notée hr et une dimension latérale moyenne, dans le plan XY, notée Ir. Ils peuvent présenter une section, dans le plan XY, carré, rectangulaire, polygonale voire circulaire, ovale ou autre. Les plots 20 sont dits épais dans le sens où leur hauteur hᵣ est supérieure ou égale à au moins le dixième de la dimension latérale Iᵣ, voire est supérieure ou égale au cinquième de cette dimension latérale Ir, voire est supérieure ou égale à cette dimension latérale Ir. Les plots épais 20 se distinguent ainsi des masques se présentant sous la forme de portions de couche mince, dans lesquelles la hauteur des portions est inférieure à au moins le dixième de sa dimension latérale.

Les plots 20 sont espacés ici périodiquement les uns des autres, avec un pas noté p, et sont espacés les uns des autres d'une valeur moyenne notée e. A titre purement illustratif, dans cet exemple, le pas p est égal à 5µm environ, et les plots de gravure 20 sont des plots à section circulaire dans le plan XY de 2µm de diamètre et de 3µm de hauteur. Aussi, deux plots adjacents sont espacés l'un de l'autre d'une distance moyenne e de l'ordre de 1µm. Les plots peuvent présenter une section de forme différente, par exemple polygonale, telle que carrée ou rectangulaire.

En référence à la figure 2C, on effectue une étape de gravure chimique de la couche utile 3 pour former une matrice 1 de photodiodes 2 de structure mesa. La gravure chimique est une gravure humide réalisée en phase liquide ou en phase vapeur, par exemple en utilisant un agent de gravure tel que le brome.

On obtient ainsi la suppression partielle de la couche utile 3 à partir de la surface exposée de la face supérieure 3a, formant ainsi une pluralité de structures en mesa 2 situées sous les plots de gravure 20. Chaque structure en mesa 2 comporte ainsi une portion 6 dopée P issue de la zone supérieure 16 dopée P, surmontant une portion 7 dopée N issue de la région 18 dopée N de la zone inférieure 17. On obtient ainsi une pluralité de jonctions PN distinctes les unes des autres, formant ainsi des photodiodes 2.

Chaque structure en mesa 2 présente ainsi une surface supérieure 8 sur laquelle repose un plot de gravure 20, ainsi que des surfaces latérales, ou flancs 9, ici exposées c'est-à-dire non recouvertes par le plot de gravure 20. Les flancs 9 des structures en mesa 2 se rejoignent au niveau d'une surface inférieure 10. On définit ainsi la profondeur hₘ de la structure en mesa 2 comme la distance maximale, suivant l'axe Z, entre la surface inférieure 10 et la surface supérieure 8. De manière avantageuse, la profondeur hₘ des structures en mesa 2 est telle que la surface inférieure 10 affleure ou est située au niveau de la région 19 dopée N+. On limite ainsi les effets dits de *crosstalk* entre les photodiodes 2, c'est-à-dire le fait qu'un porteur minoritaire photogénéré au niveau d'une photodiode 2 puisse être détecté par une photodiode 2 voisine. Par ailleurs, la région 19 dopée N+ est avantageusement non gravée sur toute son épaisseur, de manière à former une base s'étendant sous les photodiodes 2 destinée à l'application ultérieure d'un même potentiel électrique à l'ensemble des photodiodes 2.

La gravure chimique étant humide, la suppression partielle de la couche utile 3 à partir de la face supérieure 3a exposée est sensiblement isotrope, c'est-à-dire qu'elle provoque la suppression d'une partie de la couche utile 3 située sous la face supérieure 3a exposée, mais également d'une partie de la couche utile 3 située sous les plots de gravure 20. La surface supérieure 8 des portions 6 dopées P présentent donc une dimension latérale moyenne, notée Iₘ, dans le plan XY, inférieure à celle Iᵣ des plots de gravure 20. Cela se traduit par la formation d'un décrochement 21 entre la face latérale de chaque plot de gravure 20 et les flancs 9 de la structure en mesa 2 correspondante, au niveau de la surface de contact entre le plot de gravure 20 et la structure en mesa 2.

Du fait de ce décrochement 21, chaque plot forme un surplomb 21 au-dessus des flancs 9 de la structure en mesa 2. Ce surplomb 21, ou ce décrochement, présente une dimension notée d, correspondant à la distance maximale entre une face latérale ou verticale du plot de gravure 20 et le flanc 9 en regard de la structure en mesa 2, au niveau de la surface de contact 8 entre le plot de gravure 20 et la structure en mesa 2. La dimension d est mesurée dans un plan parallèle au plan XY principal de la couche utile 3. La dimension d est de l'ordre de quelques dizaines de nanomètres, et est avantageusement supérieure ou égale à 50nm environ, par exemple égale à 65nm environ.

Comme il sera détaillé plus loin, il est avantageux que la hauteur hr des plots de gravure 20 et la profondeur hm des structures en mesa 2 soient telles que le rapport hr/hm soit supérieur ou égal à 2. Ce rapport peut être obtenu par le dimensionnement des plots de gravure 20 et par l'adaptation de la vitesse et/ou du temps de gravure humide.

Il est également avantageux que les plots de gravure 20 soient dimensionnés et espacés de sorte que le rapport hr/e de la hauteur hr des plots sur l'espacement e entre deux plots 20 adjacents soit supérieur à 1.

En référence à la figure 2D, on réalise un dépôt conforme d'une couche de passivation 14 sur les plots de gravure 20 et les flancs 9 des structures en mesa 2. La couche de passivation 14 peut être déposée par une technique de dépôt conforme telle que le dépôt physique en phase vapeur, par exemple, la pulvérisation cathodique (*sputtering,* en anglais), par exemple la pulvérisation par faisceau ionique (IBS pour *Ion Beam Sputtering,* en anglais), voire le dépôt de couche atomique (ALD, pour *Atomic Layer Deposition,* en anglais). La couche de passivation 14 recouvre ainsi les faces exposées des plots de gravure 20, ainsi que la surface exposée des structures en mesa 2, à savoir les flancs 9 et la surface inférieure 10. La quantité de matière déposée est choisie de sorte que l'épaisseur locale de la couche de passivation 14 sous le décrochement 21 soit au plus égale à 200nm. Cette épaisseur locale est mesurée sous le décrochement 21, c'est-à-dire sur le flanc de la photodiode situé à la perpendiculaire du décrochement 21. Par ailleurs, la température et la pression de dépôt sont préalablement choisies de sorte que la couche de passivation 14 présente une structure polycristalline représentative de la zone 2 du diagramme de Thornton. Ce diagramme est présenté notamment dans la publication de J.A. Thornton, J. Vac. Sci. Technol. 11 (1974) 666. Il illustre les différentes zones microstructurales de la couche mince polycristalline déposée, en fonction du rapport T/T_{f} de la température de dépôt T sur la température de fusion T_{f} du matériau déposé, et de la pression de dépôt. Selon ce diagramme, au moins trois zones principales peuvent être obtenues. Une première zone, obtenue pour les faibles valeurs de T/T_{f}, correspond à une microstructure de la couche déposée formée de grains fibreux et texturés dont la surface d'extrémité est en forme de dôme. Une deuxième zone, obtenue pour les valeurs intermédiaires de T/T_{f}, pour laquelle la microstructure, dont la densité est plus élevée, est formée de grains colonnaires qui s'étendent longitudinalement suivant toute l'épaisseur de la couche avec une dimension transversale sensiblement constante suivant leur axe longitudinal. Les colonnes sont séparées latéralement les unes des autres par des joints de grains. Enfin, une troisième zone dans laquelle la microstructure est formée de grains non colonnaires mais équiaxes.

La couche de passivation 14 est réalisée en au moins un matériau semiconducteur ou diélectrique, et non pas en un matériau métallique. Dans le cas d'au moins un matériau semiconducteur, il présente avantageusement une énergie de bande interdite supérieure à celle du matériau des mesas, et présente une propriété d'isolation électrique. A titre d'exemple, la couche de passivation 14 peut être formée d'une première sous-couche de CdTe revêtue d'une deuxième sous-couche de ZnS. Une telle couche de passivation 14 présente ainsi une énergie de bande interdite supérieure à celle du CdHgTe des structures en mesa 2, et est électriquement isolante. D'autres matériaux de passivation peuvent être utilisés, comme par exemple les oxydes de silicium SiOₓ. Elle peut présenter une épaisseur locale non nulle, allant de quelques dizaines de nanomètres à quelques centaines de nanomètres, par exemple comprise entre 50nm et 1000nm, par exemple égale à 500nm environ. La quantité de matériau déposé est toutefois choisie de sorte que l'épaisseur locale de la couche de passivation 14 sous le décrochement 21 est au plus égale à 200nm. Par ailleurs, la structure polycristalline colonnaire représentative de la zone 2 du diagramme de Thornton peut être obtenue pour une pression de dépôt de 10⁻³ mbar et une température normalisée T/T_{f} de l'ordre de 0,1.

Les inventeurs ont mis en évidence que le dépôt conforme d'une couche de passivation 14 sur les plots de gravure 20 et les flancs 9 des structures en mesa 2, effectué de telle sorte que l'épaisseur locale de la couche 14 déposée sous le décrochement 21 reste inférieure ou égale à 200nm d'une part, avec des conditions de dépôt adaptées à l'obtention d'une couche 14 dont la structure polycristalline est caractéristique de la zone 2 du diagramme de Thornton d'autre part, autorise alors la réalisation ultérieure d'un *lift-off,* tout en assurant une passivation suffisante des flancs de la photodiode . En effet, la diminution de l'épaisseur de la couche de passivation 14 à mesure que l'on se rapproche de la ligne de contact entre les plots 20 et les structures en mesa 2, en particulier sous le décrochement 21, associée à la structure cristallographique de la couche 14, permettront la dissolution chimique des plots de gravure 20 lors de l'étape suivante. La couche de passivation 14 présente une densité permettant d'assurer une bonne passivation des flancs de la photodiode, et sa structure colonnaire homogène autorise la diffusion du solvant lors de l'étape ultérieure de *lift-off.*

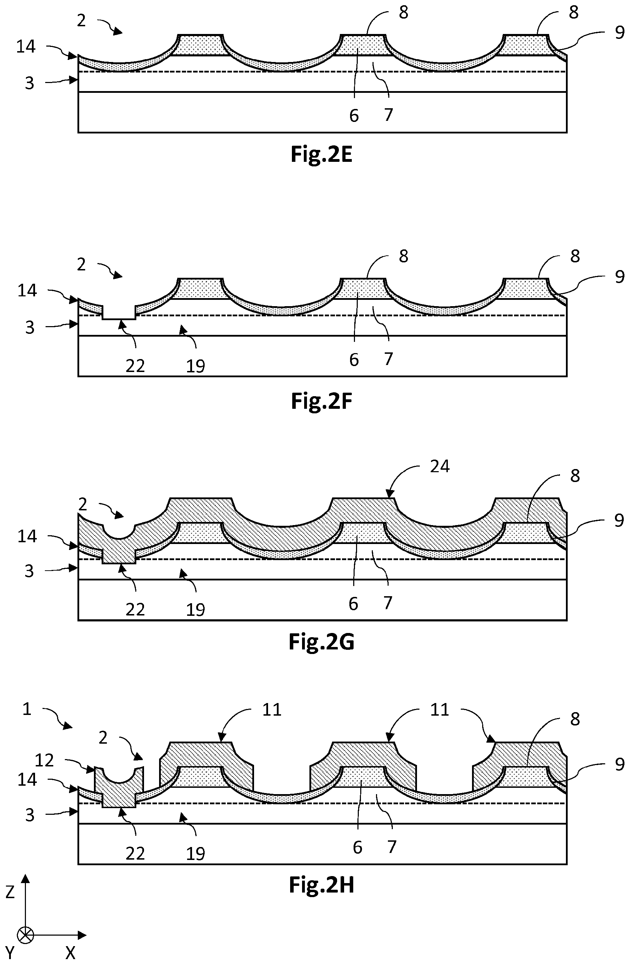

En référence à la figure 2E, on réalise ensuite la dissolution chimique des plots de gravure 20 à l'aide d'un solvant, ce qui entraîne la suppression de la partie de la couche de passivation 14 recouvrant les plots de gravure 20 *(lift-off,* en anglais). La suppression des plots est rendue possible par l'épaisseur mince de la couche de passivation 14 sous le décrochement 21 et à sa structure colonnaire représentative de la zone 2 du diagramme de Thornton, qui autorisent localement au solvant d'accéder aux plots de gravure 20.

On obtient donc des photodiodes 2 à structures en mesa dont la surface supérieure 8 des portions 6 dopées P est exposée, c'est-à-dire non revêtue par une autre couche, et dont les flancs 9 sont recouverts par la couche de passivation 14. En d'autres termes, on obtient l'auto-alignement de la couche de passivation 14 vis-à-vis des structures en mesa 2 dans la mesure où la couche de passivation 14 recouvre continûment et entièrement les flancs 9 sans recouvrir pour autant la surface supérieure 8. On évite ainsi toute imprécision sur le positionnement de la couche de passivation 14 vis-à-vis des structures en mesa 2. Par ailleurs, cet auto-alignement de la couche de passivation 14 est obtenu par une technique de *lift-off* d'un matériau passivant semiconducteur ou diélectrique, et non pas d'un matériau métallique comme dans l'exemple de l'art antérieur mentionné précédemment, ce qui est par ailleurs contraire aux connaissances générales de l'homme du métier qui réserve habituellement la technique de *lift-off* aux matériaux métalliques.

Une étape facultative de recuit peut être effectuée, dans le but de provoquer une diffusion d'une partie du cadmium contenu dans la couche de passivation 14 dans une zone de la couche utile 3 bordant les flancs 9. Il s'ensuit une augmentation locale de la proportion atomique de cadmium dans la couche active au niveau des flancs 9 des photodiodes 2, ce qui se traduit par une augmentation locale de l'énergie de bande interdite, et contribue ainsi à améliorer la qualité de la passivation des flancs 9 des photodiodes 2.

Le procédé de réalisation de la matrice 1 de photodiodes 2 comporte ensuite des étapes de formation des contacts diode 11 et d'au moins un contact substrat 12.

Dans le cadre de ce mode de réalisation, en référence à la figure 2F, on réalise au moins une échancrure 22 dans la couche utile 3, dans le but de réaliser ultérieurement au moins un plot conducteur permettant l'application d'un même potentiel électrique commun à toutes les photodiodes 2, à savoir le contact substrat 12. Pour cela, l'échancrure 22 est réalisée au travers de la couche de passivation 14 et de la couche utile 3, jusqu'à atteindre la base, à savoir ici la région 19 dopée N+. L'échancrure 22 est obtenue par des étapes classiques de photolithographie et gravure. Elle peut présenter une dimension latérale dans le plan XY de l'ordre de quelques microns, par exemple comprise entre 1µm et 5µm.

En référence aux figures 2G et 2H, on réalise les contacts diode 11 et le contact substrat 12, ici de manière simultanée, de préférence par une technique d'auto-alignement des contacts diode 11 vis-à-vis des structures en mesa 2.

Pour cela, on effectue un dépôt d'une même couche électriquement conductrice 24 qui vient recouvrir continûment la couche de passivation 14 et les surfaces supérieures 8 des structures en mesa 2. La couche conductrice 24 recouvre ainsi toute la surface supérieure 8 des portions 6 dopées P des photodiodes 2 et vient au contact de la région 19 dopée N+ au niveau de la ou des échancrures 22. La couche conductrice 24 peut présenter une épaisseur de l'ordre de quelques microns, par exemple comprise entre 1µm et 5µm, par exemple égale à 1µm environ, et être réalisée en au moins un matériau électriquement conducteur, tel qu'un matériau métallique, par exemple du molybdène.

Les contacts diode 11 et le ou les contacts substrat 12 sont réalisés ensuite de manière simultanée par structuration de la couche conductrice 24, au moyen d'étapes classiques de photolithographie et gravure. On obtient ainsi une pluralité de plots conducteurs, distincts les uns des autres, à savoir les contacts diode 11 au contact des surfaces supérieures 8 des photodiodes 2, et au moins un contact substrat 12 au contact de la base 19 de la couche utile 3.

De manière avantageuse, chaque contact diode 11 est structuré de sorte qu'il recouvre entièrement la surface supérieure 8 des portions 6 dopées P des photodiodes 2.

De plus, il est avantageux que chaque contact diode 11 recouvre également une partie des flancs 9 entourant la surface supérieure 8 de la photodiode 2 correspondante. La surface des contacts diode 11 est alors supérieure à celle de la surface supérieure 8 des photodiodes 2.

Ainsi, on obtient un auto-alignement des contacts diode 11 vis-à-vis des photodiodes 2, ce qui permet d'éviter les imprécisions de positionnement. De plus, le recouvrement des flancs 9 des photodiodes 2 par les contacts diode 11, au niveau d'une zone où la couche de passivation 14 est susceptible d'être plus mince, permet d'améliorer la qualité de la passivation. De préférence, la couche de passivation 14 est recouverte par les contacts diode 11 sur une distance, dans le plan XY, supérieure ou égale à la dimension d du surplomb 21.

On obtient ainsi une matrice 1 de photodiodes 2 à structures en mesa, où la couche de passivation 14 est auto-alignée vis-à-vis des structures en mesa 2, c'est-à-dire qu'elle recouvre continûment les flancs 9 des structures en mesa 2 sans recouvrir la surface supérieure 8 de celles-ci. De plus, les contacts diode 11 sont avantageusement auto-alignés vis-à-vis des photodiodes 2, c'est-à-dire qu'ils recouvrent entièrement les surfaces supérieures de celles-ci, ainsi qu'une partie de la couche de passivation 14 entourant les surfaces supérieures.

Ce procédé de réalisation est particulièrement avantageux lorsqu'on souhaite réaliser une matrice 1 de photodiodes 2 à petit pas, par exemple à pas inférieur ou égal à 10µm, voire inférieur ou égal à 5µm. En effet, la couche de passivation 14 et les contacts diode 11 restent alignés vis-à-vis des photodiodes 2 sans être affectés par les incertitudes de positionnement des masques de gravure ou de dépôt.

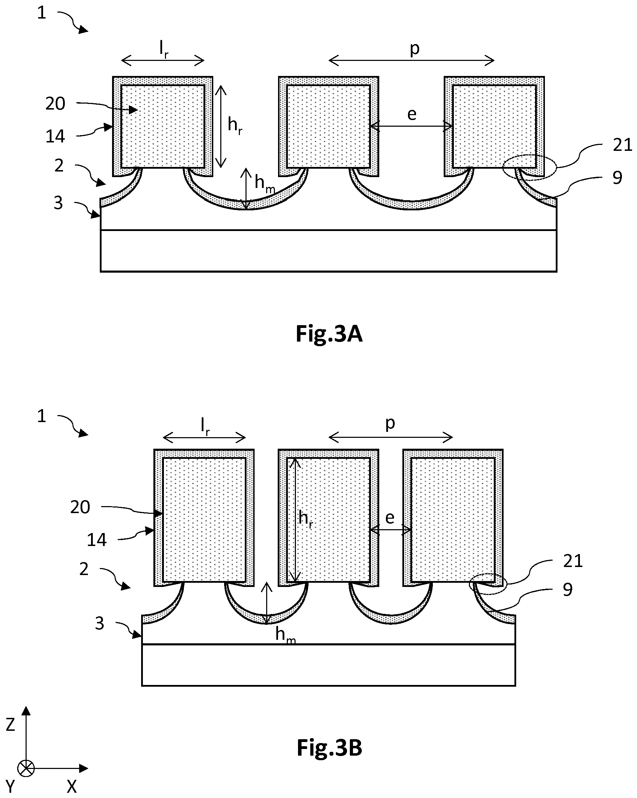

Les figures 3A et 3B sont des vues en coupe, schématiques et partielles, d'une matrice 1 de photodiodes 2 obtenue à la suite de l'étape de dépôt de la couche de passivation 14 décrite précédemment en référence à la figure 2D, ici pour différents exemples de dimensionnement des plots de gravure 20.

Comme mentionné précédemment, dans le but de faciliter le *lift-off* de la couche de passivation 14 recouvrant les plots de gravure 20, il est avantageux que la hauteur hr des plots de gravure 20 et la profondeur hm des structures en mesa 2 soient telles que le rapport hr/hm soit supérieur ou égal à 2.

Dans l'exemple de la figure 3A, le pas p est de l'ordre de 4µm. Les plots de gravure 20 présentent une hauteur hr de 2µm environ et une dimension latérale moyenne de 2µm environ, et sont donc espacés d'une distance moyenne e de 2µm. La profondeur hm des structures en mesa 2 est de l'ordre de 1µm, et la dimension d du décrochement 21 est de 65nm environ. Le rapport hr/hm est ici égal à 2. L'épaisseur locale de la couche de passivation 14 diminue à mesure qu'on se rapproche de la surface supérieure 8, et donc du décrochement 21, ce qui, du fait de la structure colonnaire de la couche de passivation 14 (zone 2 du diagramme de Thornton), permettant ainsi au solvant d'accéder aux plots de gravure 20 lors de l'étape de dissolution chimique des plots et donc de *lift-off* d'une partie de la couche de passivation 14.

Par ailleurs, cette étape de *lift-off* est encore facilitée lorsque les plots de gravure 20 sont dimensionnés et espacés de sorte que le rapport hr/e de la hauteur hr des plots sur l'espacement e entre les plots est supérieur à 1.

Dans l'exemple de la figure 3B, le pas p est de l'ordre de 3µm. Les plots de gravure 20 présentent une hauteur hr de 3µm environ pour une dimension latérale moyenne de 2µm environ. Ils sont donc espacés d'une distance moyenne e de 1µm. La profondeur hm des structures en mesa 2 est de l'ordre de 1µm, et la dimension d du décrochement 21 est de 65nm environ. Le rapport hr/hm est ici égal à 3 environ et le rapport hr/e est égal à 3 environ. Comme l'illustre la figure, l'épaisseur locale de la couche de passivation 14 diminue davantage à mesure qu'elle s'approche de la ligne de contact entre les flancs 9 et la surface des plots. Cela facilite l'accès du solvant jusqu'aux plots de gravure 20, améliorant ainsi l'étape de *lift-off* est alors encore facilitée.

Des modes de réalisation particuliers viennent d'être décrits. Différentes variantes et modifications apparaîtront à l'homme du métier.

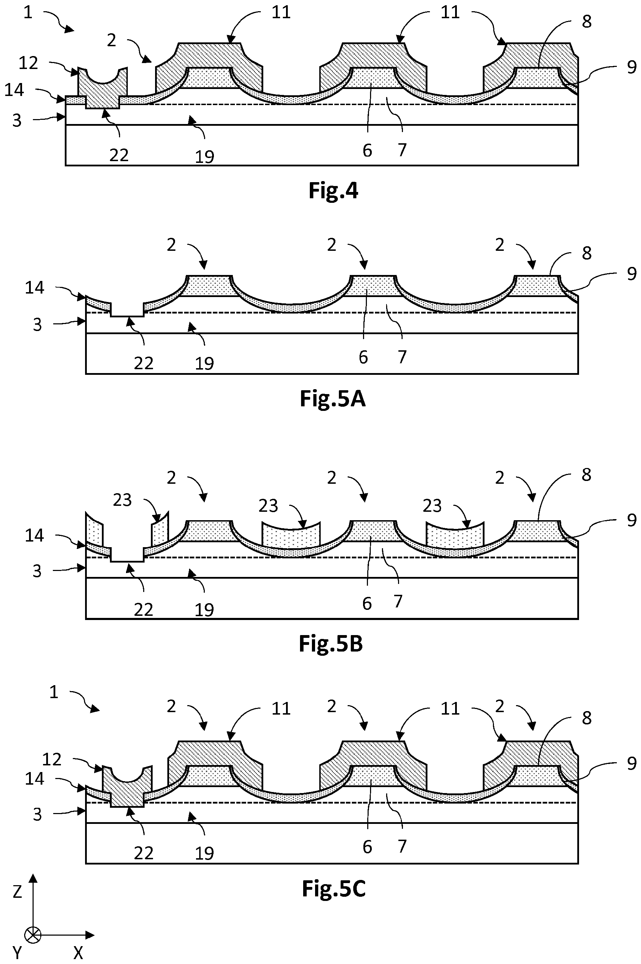

Comme l'illustre la figure 4, en variante de l'exemple de réalisation précédent dans lequel le ou les contacts substrat 12 sont situés entre deux structures en mesa 2, le ou les contacts substrat 12 peuvent être situés à distance de la matrice 1 de photodiodes 2, notamment dans une zone de la couche utile 3 à épaisseur sensiblement constante et ne comportant pas de structures en mesa.

Par ailleurs, comme l'illustrent les figures 5A à 5C, les contacts diode 11 et le ou les contacts substrat 12 peuvent être réalisés, simultanément ou non, par une technique de *lift-off.* A la suite de la formation du ou des échancrures 22 (fig.5A), on forme par photolithographie des plots 23 d'un masque de dépôt, par exemple une résine photosensible, sur une partie de la couche de passivation 14 ne recouvrant pas les surfaces supérieures 8 des photodiodes 2 ni la ou les échancrures 22 (fig.5B). On dépose ensuite une même couche métallique sur la surface exposée de la matrice 1 de photodiodes 2, c'est-à-dire la surface non recouverte par les plots 23 du masque, ainsi que sur les plots 23 du masque. On réalise ensuite la suppression (*lift-off*) de la partie de la couche conductrice recouvrant les plots par dissolution chimique des plots du masque, ce qui est possible par le fait que la couche conductrice est ici métallique (fig.5C). On obtient ainsi une matrice 1 de photodiodes 2 à structures en mesa identique ou similaire à celle décrite sur la figure 2H.

La matrice 1 de photodiodes 2 décrite précédemment comporte au moins un contact substrat 12 réalisé au niveau de la face supérieure 3a de la couche utile 3, c'est-à-dire du même côté que celui des contacts diode 11. En variante, la ou les contacts substrat 12 peuvent être réalisé au niveau de la face inférieure 3b de la couche utile 3, en particulier lorsque le substrat de croissance a été supprimé.

Les photodiodes décrites précédemment comportent chacune une portion dopée P recouvrant une portion dopée N (technologie dite P sur N). Les types de dopage peuvent être bien entendu inversés, pour réaliser ainsi des photodiodes de type N sur P.

Comme mentionné précédemment, la couche support peut ensuite être supprimée. L'épaisseur moyenne de la couche utile, et notamment de la base, est alors adaptée de manière à assurer une tenue mécanique à la matrice de photodiodes.

La matrice de photodiodes à structures en mesa peut avantageusement comporter une pluralité de cavités optiques résonantes réalisées chacune en un plot d'un matériau diélectrique disposé en regard d'une photodiode et couplé optiquement avec celle-ci. Une telle cavité optique résonante peut être identique à celle décrite dans la demande FR3032304.

## Revendications

1. Procédé de réalisation d'une matrice (1) de photodiodes (2) à structures en mesa, comportant au moins les étapes suivantes :
a) réalisation d'une couche dite utile (3) comportant une face supérieure (3a) et une face inférieure (3b) opposée, reposant sur une couche support (15) au niveau de la face inférieure (3b), comportant un empilement d'une première zone (16) située au niveau de la face supérieure (3a) et présentant un premier type de dopage, et d'une deuxième zone (17) située entre la première zone (16) et la couche support (15) présentant un deuxième type de dopage opposé au premier type ;
b) réalisation d'un masque de gravure disposé sur ladite face supérieure (3a), formé d'une pluralité de plots dits de gravure (20) distincts les uns des autres ;
c) gravure humide d'une partie de la couche utile (3) située entre les plots de gravure (20), formant ainsi une pluralité de photodiodes (2) à structures en mesa présentant chacune une surface supérieure (8) sur laquelle repose l'un desdits plots de gravure (20), ladite gravure humide étant adaptée de sorte que la surface supérieure (8) de chaque photodiode (2) présente une dimension latérale moyenne inférieure à celle du plot de gravure (20) correspondant, formant ainsi un décrochement (21) entre le plot de gravure (20) et la photodiode (2) correspondante ;
d) dépôt conforme, sur les plots de gravure (20) et les photodiodes (2), d'une couche de passivation (14) en au moins un matériau diélectrique ou semiconducteur, avec des conditions de dépôt choisies de sorte que la couche de passivation présente d'une part une épaisseur locale inférieure ou égale à 200nm sous le décrochement (21), et d'autre part une structure polycristalline colonnaire dont les colonnes s'étendent longitudinalement suivant l'épaisseur de la couche de passivation (21) avec une dimension transversale constante, et sont séparées latéralement les unes des autres par des joints de grains ;
e) suppression des plots de gravure (20) par dissolution chimique, laissant ainsi exposée la surface supérieure (8), une surface dite latérale (9) des photodiodes, qui entoure la surface supérieure (8), étant recouverte par la couche de passivation (14) ;
f) réalisation de plots électriquement conducteurs (11) sur et au contact de la surface supérieure (8).

2. Procédé selon la revendication 1, dans lequel, lors de l'étape de réalisation des plots conducteurs (11), chaque plot conducteur (11) recouvre entièrement la surface supérieure (8) de la photodiode (2) correspondante.

3. Procédé selon la revendication 2, dans lequel chaque plot conducteur (11) recouvre en outre une partie d'une surface latérale (9) de la photodiode (2) correspondante qui entoure la surface supérieure (8).

4. Procédé selon l'une quelconque des revendications 1 à 3, dans lequel les plots de gravure (20) sont dimensionnés et la gravure humide est adaptée de sorte que le rapport entre une hauteur (hᵣ) des plots de gravure (20) sur une profondeur (hₘ) des photodiodes (2) est supérieur ou égal à 2.

5. Procédé selon l'une quelconque des revendications 1 à 4, dans lequel les plots de gravure (20) sont dimensionnés de sorte que le rapport entre une hauteur (hᵣ) des plots de gravure (20) sur un espacement (e) entre deux plots de gravure (20) adjacents est supérieur à 1.

6. Procédé selon l'une quelconque des revendications 1 à 5, dans lequel les photodiodes (2) sont espacées les uns des autres périodiquement d'un pas (p) inférieur ou égal à 10µm.

7. Procédé selon l'une quelconque des revendications 1 à 6, dans lequel le décrochement (21) présente une dimension (d), suivant une direction parallèle à un plan principal de la couche utile (3), supérieure à 50nm.

8. Procédé selon l'une quelconque des revendications 1 à 7, dans lequel la couche utile (3) est réalisée en un alliage semiconducteur comportant des éléments des colonnes II et VI du tableau périodique.

9. Procédé selon la revendication 8, dans lequel la couche de passivation (14) est réalisée en au moins un alliage semiconducteur comportant des éléments des colonnes II et VI du tableau périodique.

10. Procédé selon l'une quelconque des revendications 1 à 9, dans lequel la couche de passivation (14) est déposée par pulvérisation cathodique.

11. Procédé selon l'une quelconque des revendications 1 à 10, dans lequel la couche de passivation (14) présente une épaisseur, au niveau de la surface latérale (9) des photodiodes (2), qui diminue à mesure que l'on se rapproche de la surface supérieure (8).

12. Procédé selon l'une quelconque des revendications 1 à 11, dans lequel l'étape de réalisation des plots conducteurs (11) comporte un dépôt d'une couche continue (24) en un matériau électriquement conducteur de manière à recouvrir la couche de passivation (14) et la surface supérieure (8) des photodiodes (2), suivi d'une structuration de la couche continue (24) sous forme de plots conducteurs (11) distincts les uns des autres par photolithographie et gravure.

## Patentansprüche

1. Verfahren zur Ausführung einer Matrix (1) aus Fotodioden (2) mit Mesa-Strukturen, das mindestens die folgenden Schritte umfasst:
a) Ausführen einer Schicht, Nutzschicht (3) genannt, die eine Oberseite (3a) und eine entgegengesetzte Unterseite (3b) umfasst, an der Unterseite (3b) auf einer Trägerschicht (15) aufliegt, einen Stapel aus einer ersten Zone (16), die an der Oberseite (3a) gelegen ist und eine erste Dotierungsart aufweist, und aus einer zweiten Zone (17), die zwischen der ersten Zone (16) und der Trägerschicht (15) gelegen ist und eine zweite Dotierungsart aufweist, die zur ersten Art entgegengesetzt ist, umfasst;
b) Ausführen einer Ätzmaske, die auf der Oberseite (3a) angeordnet wird und aus einer Vielzahl von Höckern, Ätzhöcker (20) genannt, gebildet ist, die voneinander getrennt sind;
c) Nassätzen eines Teils der Nutzschicht (3), der zwischen den Ätzhöckern (20) gelegen ist, so dass eine Vielzahl von Fotodioden (2) mit Mesa-Strukturen gebildet wird, die jeweils eine obere Fläche (8) aufweisen, auf der einer der Ätzhöcker (20) aufliegt, wobei das Nassätzen so angepasst ist, dass die obere Fläche (8) jeder Fotodiode (2) ein mittleres seitliches Maß aufweist, das kleiner als das des entsprechenden Ätzhöckers (20) ist, so dass ein Rücksprung (21) zwischen dem Ätzhöcker (20) und der entsprechenden Fotodiode (2) gebildet wird;
d) konformes Abscheiden einer Passivierungsschicht (14) aus mindestens einem dielektrischen oder Halbleitermaterial auf den Ätzhöckern (20) und den Fotodioden (2), wobei die Abscheidebedingungen so gewählt sind, dass die Passivierungsschicht zum einen eine lokale Dicke kleiner als oder gleich 200 nm unter dem Rücksprung (21) aufweist und zum anderen eine säulenförmige polykristalline Struktur, deren Säulen sich längs entlang der Dicke der Passivierungsschicht (21) mit einem konstanten Quermaß erstrecken und seitlich voneinander durch Korngrenzen getrennt sind;
e) Entfernen der Ätzhöcker (20) durch chemisches Auflösen, so dass die obere Fläche (8) freigelegt wird, wobei eine Fläche der Fotodioden, seitliche Fläche (9) genannt, welche die obere Fläche (8) umgibt, mit der Passivierungsschicht (14) bedeckt ist;
f) Ausführen von elektrisch leitenden Höckern (11) auf und im Kontakt mit der oberen Fläche (8).

2. Verfahren nach Anspruch 1, bei dem während des Schritts des Ausführens der leitenden Höcker (11) jeder leitende Höcker (11) die obere Fläche (8) der entsprechenden Fotodiode (2) vollständig bedeckt.

3. Verfahren nach Anspruch 2, bei dem jeder leitende Höcker (11) ferner einen Teil einer seitlichen Fläche (9) der entsprechenden Fotodiode (2), welche die obere Fläche (8) umgibt, bedeckt.

4. Verfahren nach einem der Ansprüche 1 bis 3, bei dem die Ätzhöcker (20) so dimensioniert sind und die Nassätzung so angepasst ist, dass das Verhältnis einer Höhe (hᵣ) der Ätzhöcker (20) zu einer Tiefe (hₘ) der Fotodioden (2) größer oder gleich 2 ist.

5. Verfahren nach einem der Ansprüche 1 bis 4, bei dem die Ätzhöcker (20) so dimensioniert sind, dass das Verhältnis einer Höhe (hᵣ) der Ätzhöcker (20) zu einem Abstand (e) zwischen zwei benachbarten Ätzhöckern (20) größer als 1 ist.

6. Verfahren nach einem der Ansprüche 1 bis 5, bei dem die Fotodioden (2) um eine Schrittweite (p) kleiner oder gleich 10 µm periodisch voneinander beabstandet sind.

7. Verfahren nach einem der Ansprüche 1 bis 6, bei dem der Rücksprung (21) ein Maß (d) entlang einer Richtung parallel zu einer Hauptebene der Nutzschicht (3) von mehr als 50 nm aufweist.

8. Verfahren nach einem der Ansprüche 1 bis 7, bei dem die Nutzschicht (3) aus einer Halbleiterlegierung ausgeführt ist, die Elemente aus den Spalten II und VI des Periodensystems beinhaltet.

9. Verfahren nach Anspruch 8, bei dem die Passivierungsschicht (14) aus mindestens einer Halbleiterlegierung ausgeführt ist, die Elemente aus den Spalten II und VI des Periodensystems beinhaltet.

10. Verfahren nach einem der Ansprüche 1 bis 9, bei dem die Passivierungsschicht (14) durch Sputtern abgeschieden wird.

11. Verfahren nach einem der Ansprüche 1 bis 10, bei dem die Passivierungsschicht (14) an der seitlichen Fläche (9) der Fotodioden (2) eine Dicke aufweist, die zur oberen Fläche (8) hin abnimmt.

12. Verfahren nach einem der Ansprüche 1 bis 11, bei dem der Schritt des Ausführens der leitenden Höcker (11) ein Abscheiden einer durchgehenden Schicht (24) aus einem elektrisch leitenden Material derart umfasst, dass die Passivierungsschicht (14) und die obere Fläche (8) der Fotodioden (2) bedeckt sind, gefolgt von einer Strukturierung der durchgehenden Schicht (24) in Form von leitenden Höckern (11), die voneinander getrennt sind, durch Fotolitografie und Ätzen.

## Claims

1. Process for producing an array (1) of mesa-structured photodiodes (2), including at least the following steps:
a) producing a layer, referred to as the useful layer (3), including an upper face (3a) and an opposite lower face (3b), resting on a carrier layer (15) via the lower face (3b), including a stack of a first zone (16) located at the upper face (3a) and having a first doping type, and of a second zone (17) located between the first zone (16) and the carrier layer (15) having a second doping type, opposite the first type;
b) producing an etch mask positioned on said upper face (3a), formed of a plurality of pads, referred to as etch pads (20), which are distinct from one another;
c) wet-etching part of the useful layer (3) located between the etch pads (20), thus forming a plurality of mesa-structured photodiodes (2), each having an upper surface (8) on which one of said etch pads (20) rests, said wet etch being adapted so that the upper surface (8) of each photodiode (2) has a mean lateral dimension that is smaller than that of the corresponding etch pad (20), thus forming a recess (21) between the etch pad (20) and the corresponding photodiode (2);
d) conformally depositing, on the etch pads (20) and the photodiodes (2), a passivation layer (14) made of at least one dielectric or semiconductor material, with deposition conditions chosen so that the passivation layer has a local thickness that is less than or equal to 200 nm below the recess (21), and a columnar polycrystalline structure, the columns of which extend longitudinally along the thickness of the passivation layer (21) with a constant transverse dimension, and are separated laterally from one another by grain boundaries;
e) removing the etch pads (20) by chemical dissolution, thus leaving the upper surface (8) exposed, a surface, referred to as the lateral surface (9), of the photodiodes, which surrounds the upper surface (8), being covered by the passivation layer (14);
f) producing electrically conductive pads (11) on and in contact with the upper surface (8).

2. Process according to Claim 1, wherein, in the step of producing the conductive pads (11), each conductive pad (11) entirely covers the upper surface (8) of the corresponding photodiode (2).

3. Process according to Claim 2, wherein each conductive pad (11) further covers part of a lateral surface (9) of the corresponding photodiode (2) which surrounds the upper surface (8).

4. Process according to any one of Claims 1 to 3, wherein the etch pads (20) are dimensioned and the wet etch is adapted such that the ratio of a height (hᵣ) of the etch pads (20) to a depth (hₘ) of the photodiodes (2) is higher than or equal to 2.

5. Process according to any one of Claims 1 to 4, wherein the etch pads (20) are dimensioned such that the ratio of a height (hᵣ) of the etch pads (20) to a spacing (e) between two adjacent etch pads (20) is higher than 1.

6. Process according to any one of Claims 1 to 5, wherein the photodiodes (2) are periodically spaced apart from one another by a pitch (p) that is smaller than or equal to 10 µm.

7. Process according to any one of Claims 1 to 6, wherein the recess (21) has a dimension (d), along a direction parallel to a main plane of the useful layer (3), that is greater than 50 nm.

8. Process according to any one of Claims 1 to 7, wherein the useful layer (3) is made of a semiconductor alloy including elements from groups II and VI of the periodic table.

9. Process according to Claim 8, wherein the passivation layer (14) is made of at least one semiconductor alloy including elements from groups II and VI of the periodic table.

10. Process according to any one of Claims 1 to 9, wherein the passivation layer (14) is deposited by sputtering.

11. Process according to any one of Claims 1 to 10, wherein the thickness of the passivation layer (14), at the lateral surface (9) of the photodiodes (2), decreases as it approaches the upper surface (8).

12. Process according to any one of Claims 1 to 11, wherein the step of producing the conductive pads (11) includes an operation of depositing a continuous layer (24) made of an electrically conductive material so as to cover the passivation layer (14) and the upper surface (8) of the photodiodes (2), followed by an operation of structuring the continuous layer (24) to form mutually distinct conductive pads (11) by means of photolithography and etching.
